(19) **Europäisches Patentamt**
**European Patent Office**
**Office européen des brevets**

(11) **EP 2 434 639 A1**

(12) **EUROPEAN PATENT APPLICATION**

(43) Date of publication:
**28.03.2012 Bulletin 2012/13**

(51) Int Cl.:
***H03B 5/12*** *(2006.01)*

(21) Application number: **11182274.8**

(22) Date of filing: **22.09.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **24.09.2010 GB 1016059**

(71) Applicant: **Cambridge Silicon Radio Limited Cambridge CB4 0WZ (GB)**

(72) Inventor: **Sornin, Nicolas 38700 La Tronche (FR)**

(74) Representative: **Slingsby, Philip Roy Page White & Farrer Bedford House John Street London, WC1N 2BF (GB)**

(54) **LC oscillator with switchable capacitive array**

(57) An oscillator comprising a capacitive element and an inductive element for generating an output signal having a predetermined frequency, the capacitive element comprising two or more capacitive arrays, each array having one or more capacitors that are switchably connectable in parallel with the inductive element so as to control the frequency of the output signal, and at least one of those arrays being connected to only part of the inductive element such that, when a capacitor in said one array is connected to that part, the resulting change in the frequency of the output signal is smaller than it would have been if the capacitor had been connected to the whole of the inductive element.

Figure 5b.

EP 2 434 639 A1

**Description**

The invention relates to LC oscillators and particularly to LC oscillators that comprise a switchable bank of capacitors for adjusting the output frequency of the oscillator.

A phase-locked loop (PLL) is a well known circuit for generating signals having a predetermined frequency relationship with a reference signal. In its most basic form, a phase-locked loop comprises an oscillator that is controlled by means of a feedback loop. The feedback loop takes the output of the oscillator, compares it with a reference signal and adjusts the oscillator accordingly. Typically the feedback loop comprises a divider for dividing the output signal, a phase comparator for comparing the phase of the divided signal with the reference signal and a charge pump for outputting a pulse of charge that either speeds up or slows down the oscillator, in dependence on the phase comparison. The phase-locked loop will also typically include a filter for removing spurious noise from the charge pulse before it reaches the oscillator input.

A recent trend with PLL design is to make as much as possible of the implementation digital. A 'digital' PLL is often analogous to an analogue PLL but with the phase error being converted into digital information rather than being converted into a voltage via the charge pump. The digital information can then be processed and fed-back to digitally control the frequency of the oscillator. One advantage of digitally controlling the frequency is that various calibration and compensation adjustments can be made at the oscillator input. Examples include: active pulling compensation and open loop phase modulation. However, for digital control to be workable, a digital signal must be able to precisely control the oscillator frequency.

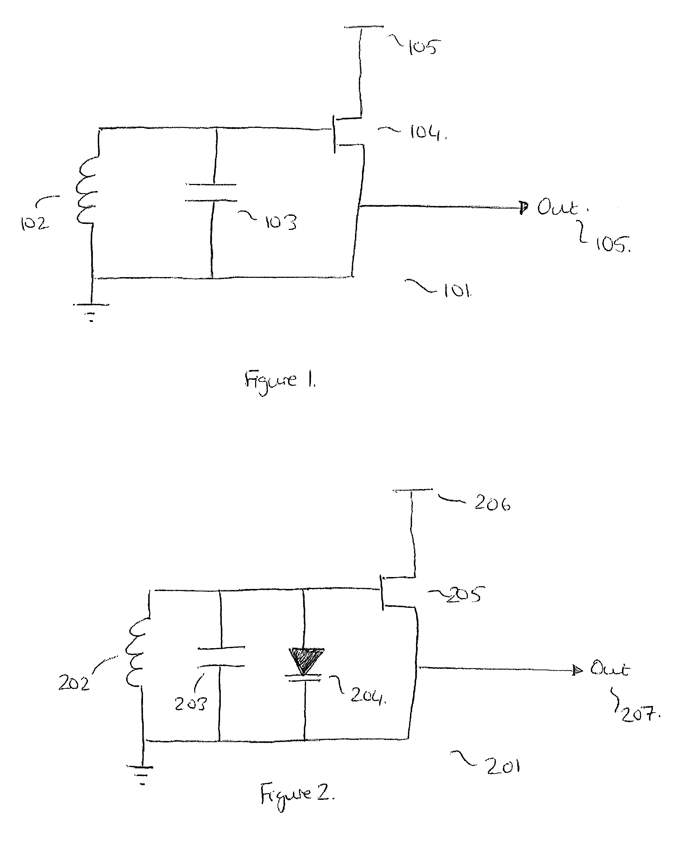

A simple schematic of an LC oscillator is shown in Figure 1. The oscillator is shown generally at 101 and comprises an inductor 102 in parallel with a capacitance 103. When capacitor 103 is charged it discharges through inductor 102, causing a magnetic field to be generated around the coil that opposes the capacitor discharge. Once the capacitor has fully discharged, the magnetic field collapses around the coil, recharging the capacitor in the opposite direction. This process generates a sine wave that would lose voltage in every cycle due to resistance were it not for power supply 105. An FET 104 is used to keep the circuit oscillating well. The oscillating output is generated at 105.

There are two principal implementations that can be used to provide digital control of the oscillator frequency. The first is shown in Figure 2. This oscillator, shown generally at 201, comprises a varactor 204 in addition to capacitor 203 and inductor 202. The varactor can be used to alter the capacitance seen by the inductor and hence the frequency of the signal 207 output by the oscillator. A problem with this implementation is the varactor linearity. The varactor is typically only linear over a small voltage range; typically over only a quarter of its total range. This is a problem for polar loop transmitters in which both a wide range of frequency tuning and good linearity are required. In addition, the combination of a digital-to-analogue converter (DAC) and a varactor adds to the phase noise of the oscillator as the thermal and flicker noise of the DAC modulates the varactor. This approach is therefore only suitable for a small frequency tuning range, e.g. a range of a few MHz with 1kHz steps.

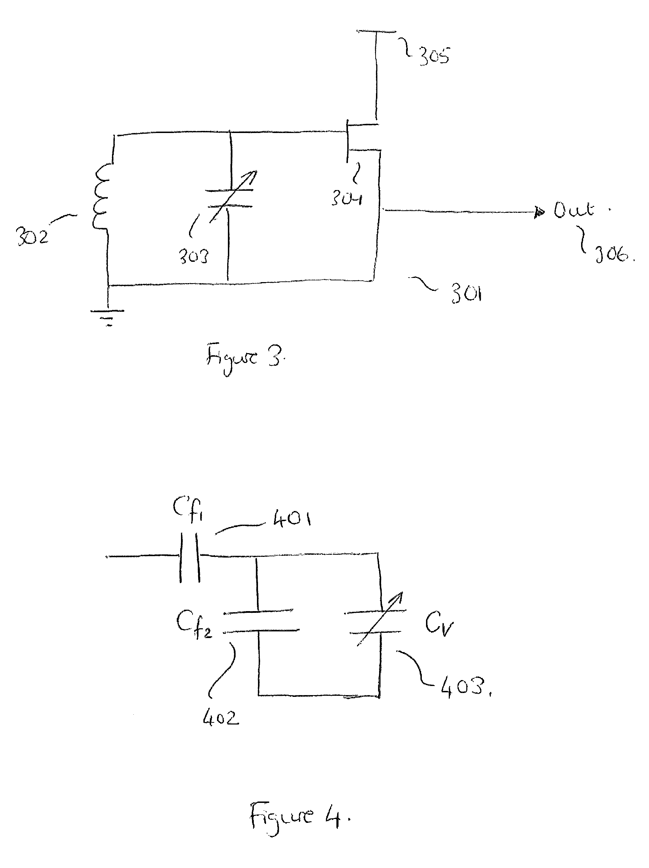

An alternative implementation is shown in Figure 3. This oscillator, shown generally at 301, comprises a variable capacitor 303. A suitable implementation for the variable capacitor is switchable bank of unit capacitors. This approach is generally preferred over the varactor option because a bank of capacitors provides very linear and precise frequency steps. A problem with this approach is that the size of the unit capacitors can become so small that the circuit cannot be implemented in a practical sense. As an example, if the maximum oscillator frequency is 4.8GHz and the wanted step size is 2MHz, an oscillator having an inductance of 2nH would require a total capacitance of 0.5pF, which is acceptable. However, the unit capacitance needed to provide the required step size would be 0.1fF. The minimum capacitance that can typically be used in an integrated circuit is approximately 10 to 15fF. 0.1fF is so small that it is exceeded by the capacitance of metal paths in an integrated circuit. A number of solutions have been proposed to address this problem.

The first option is to use a very small inductance and correlatively increase the capacitance so that it becomes acceptable. The drawback is that the VCO current increases linearly with the total capacitance value. In the example given above, the total current would have to be multiplied by at least ten for the elementary capacitance to be increased to an acceptable level.

The second option is to use a capacitive divider, such as that shown in Figure 4. Figure 4 illustrates a capacitive divider that can be used to link the capacitive bank to the terminals of the inductor. The terminals of the inductor may be connected across fixed capacitor 401. This capacitor is connected in series with a further fixed capacitor 402 and the capacitive bank 403. Because the inductor 'sees' the capacitive bank through the divider, the inductor will experience a smaller change in capacitance across its own terminals than any change in the capacitive bank. Thus, the smallest change in capacitance of the capacitive bank can be made to produce a smaller step-change in the output frequency of the oscillator than would otherwise be the case. In other words, the elementary capacitor size can be increased for a given step size. A problem, however, with this approach is that the total capacitance seen by the inductor is not a linear function of the number of capacitors switched into the capacitive bank. Instead, the inductor sees the following capacitance:

$$C_{ind} = \cfrac{1}{\cfrac{1}{C_{f1}} + \cfrac{1}{C_{f2} + C_V}}$$

(1)

A capacitive divider does not therefore provide the linearity required for digital control of the oscillator.

There is therefore a need for an improved LC oscillator for generating signals of different frequencies within a predetermined frequency range.

According to an embodiment of the invention, there is provided an oscillator comprising a capacitive element and an inductive element for generating an output signal having a predetermined frequency, the capacitive element comprising two or more capacitive arrays, each array having one or more capacitors that are switchably connectable in parallel with the inductive element so as to control the frequency of the output signal, and at least one of those arrays being connected to only part of the inductive element such that, when a capacitor in said one array is connected to that part, the resulting change in the frequency of the output signal is smaller than it would have been if the capacitor had been connected to the whole of the inductive element.

The oscillator may be capable of changing the frequency of the output signal by an amount that is dependent on the capacitor, in the array connected to the smallest part of the inductive element, that has the lowest capacitance in that array.

The oscillator may be capable of outputting a signal having a maximum frequency that is dependent on the total capacitance of the capacitors in the array connected to the largest part of the inductive element.

At least one of the capacitive arrays may be connected to the whole of the inductive element.

The inductive element may be formed of a single inductive coil, the at least one array being connected to only part of the inductive element by means of a tap on that coil.

The oscillator may be configured to connect one or more of the switchably connectable capacitors to the inductive element responsive to a control signal from a digital controller.

For a better understanding of the present invention, reference is made by way of example to the following drawings, in which:

Figure 1 shows an LC oscillator;

Figure 2 shows an LC oscillator comprising a varactor;

Figure 3 shows an LC oscillator comprising a capacitive bank;

Figure 4 shows a capacitive divider;

Figure 5a shows an LC oscillator according to the prior art; and

Figure 5b shows an LC oscillator according to an embodiment of the invention.

An oscillator capable of generating a signal at different frequencies within a predetermined frequency range may comprise a capacitive element and an inductive element. The capacitive element may comprise two or more capacitive arrays. Each array may include one or more capacitors switchably connectable in parallel with the inductive element so as to control the frequency of the output signal. One of the capacitive arrays may be connected to only part of the inductive element, so that it sees a smaller inductance another of the arrays. Since the effect that a particular capacitance has on the output frequency is dependent on the inductance it is connected to, connecting an array to only part of the inductance can be used to increase the size of capacitor required to achieve a particular frequency step. This is because a capacitor connected to only part of the inductance will produce a smaller change in the frequency of the output signal than it would have if the capacitor had been connected to the whole of the inductive element.

Each group of capacitors may comprise a plurality of capacitors connected in an array. The array may function as a variable capacitor, in which the capacitance can be adjusted by switching individual capacitors into and out of the array. Each of the capacitors in a capacitor bank may have the same value or may be of different values. For example, one option is for the capacitances within a capacitor bank to be binary-weighted so that each capacitor has twice the value of the previous capacitor in the array. Similarly, individual capacitors located in different capacitor banks may have the same or different values.

It is possible to place multiple capacitor banks along the tank inductance, so that each successive capacitor bank sees an increasing portion of the total inductance. This may be achieved for example, by placing a number of taps along a single inductive coil. Each capacitor bank can then be used to achieve different step changes in the frequency of the oscillator output. This technique can be used to assemble a high definition, digitally-controlled oscillator that is practically realisable in terms of the required capacitor values.

The capacitor banks connected to a larger portion of the inductance are capable of causing the oscillator to produce higher frequency steps for a given capacitance than those connected to a smaller portion of the inductance. The capacitor banks connected to the larger inductances are therefore suitably used to achieve the required frequency range. This helps to keep the total capacitor value as small as possible, which is beneficial since oscillator current increases linearly with total capacitor value. The capacitor banks connected to the smaller inductances are suitably used to achieve the required step size. With a smaller inductance, a larger capacitor can achieve the same frequency step as a smaller capacitor connected to a large inductance. This enables the elementary capacitor size to be increased to a practically realisable level while still achieving fine control of the oscillator output. Moreover, since another capacitor bank is responsible for achieving the desired frequency range, this fine definition can be achieved without the need for a very large total capacitance, which would lead to unacceptable current demands.

The capacitor values for the different capacitor banks are preferably selected such that the capacitors connected to larger portions of the inductance are capable of producing larger step changes in the output frequency than capacitors connected to smaller portions of the inductance. This may help to keep the total capacitance, and therefore current, to a minimum for a particular frequency range.

The oscillator is suitably arranged to output the minimum frequency of its range when all of the capacitors in the group connectable to the largest portion of the inductance are connected to that inductance. The oscillator may be arranged to output the maximum frequency of its range when all of the capacitors are disconnected from the inductance. Similarly, the oscillator may be arranged to achieve the smallest frequency step of which it is capable when the smallest capacitor that is connected to the smallest portion of the inductance is switched to being connected to that inductance.

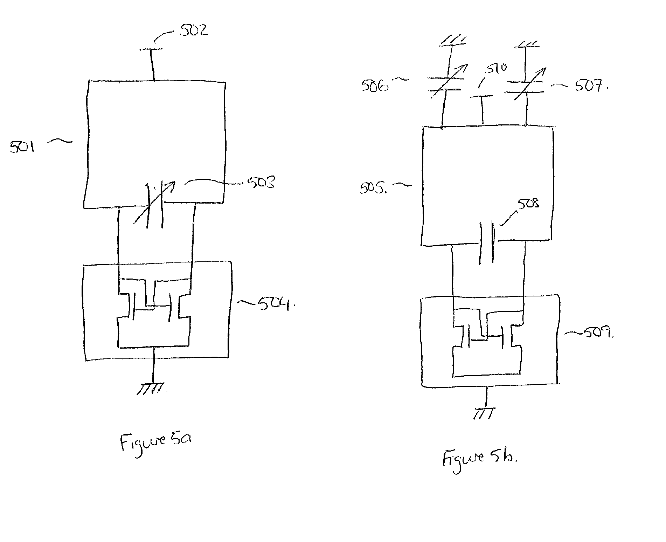

An example of an oscillator according to one embodiment of the invention is shown in Figure 5b. By way of comparison, a prior art oscillator is shown in Figure 5a. Both oscillators comprise an inductive loop, 501, 505, a power supply, 502, 510, and a switching unit 504, 509. The prior art oscillator also comprises a capacitor bank 503 connected between the terminals of the inductive loop. In the oscillator of Figure 5b, a fixed capacitor 508 is connected between the terminals of the inductive loop. The capacitive bank has been split into two sections 506, 507, with each being connected to a respective portion of the inductive loop.

As an example, an oscillator such as that shown in Figure 5b might be provided with two capacitive banks, each comprising 64 capacitors. The 64 capacitors connected to the larger portion of the inductance may each be equivalent to a 1Mhz frequency step. The 64 capacitors connected to the smaller portion of the inductance may each be equivalent to a 50kHz frequency step. The resulting oscillator would have a tuning range of 64MHz with an LSB of 50kHz. This is equivalent to approximately 10 bits of frequency control. It would be unfeasible to achieve such a fine level of control using existing oscillator design as it would require an array of 1024 matched capacitors, all individually switchable. Such an array would be very difficult to achieve in practice.

Preferably the oscillator is arranged such that there is some overlap between the coarse and fine frequency control so that the range of the fine frequency control always covers at least one LSB of the coarse frequency control. This is because the precise fine and coarse frequency control steps are typically not precisely known in advance. This is why in the example above, sixty-four 50kHz capacitors were provided even though theoretically only twenty 50kHz capacitors would be required to reach the coarse frequency LSB of 1 MHz.

Although Figure 5b shows the first and second inductances as being formed from a single inductive loop, this is for the purposes of example only. Each of the capacitive banks might be connected to a different inductive loop or coil, providing that those loops or coils are connected together to form a total tank inductance for the oscillator. Since the frequency output by an oscillator according to an embodiment of the invention may be controlled by simply switching capacitors into and out of a capacitive array, the oscillator may suitably be controlled by a digital control signal. An oscillator according to an embodiment of the invention may therefore be incorporated into a 'digital' PLL without the need for a DAC to convert a digital control signal into analogue form. Since there is no DAC to power, there is no standing current. Also, the oscillator does not suffer from the noise problems of oscillators that use a combination of a DAC and a varactor.

The applicant hereby discloses in isolation each individual feature described herein and any combination of two or more such features, to the extent that such features or combinations are capable of being carried out based on the present specification as a whole in light of the common general knowledge of a person skilled in the art, irrespective of whether such features or combinations of features solve any problems disclosed herein, and without limitation to the scope of the claims. The applicant indicates that aspects of the present invention may consist of any such feature or combination of features. In view of the foregoing description it will be evident to a person skilled in the art that various modifications may be made within the scope of the invention.

**Claims**

1. An oscillator comprising a capacitive element and an inductive element for generating an output signal having a predetermined frequency, the capacitive element comprising two or more capacitive arrays, each array having one or more capacitors that are switchably connectable in parallel with the inductive element so as to control the frequency of the output signal, and at least one of those arrays being connected to only part of the inductive element such that, when a capacitor in said one array is connected to that part, the resulting change in the frequency of the output signal is smaller than it would have been if the capacitor had been connected to the whole of the inductive element.

2. An oscillator as claimed in claim 1, wherein the oscillator is capable of changing the frequency of the output signal by an amount that is dependent on the capacitor, in the array connected to the smallest part of the inductive element, that has the lowest capacitance in that array.

3. An oscillator as claimed in claim 1, wherein the oscillator is capable of outputting a signal having a maximum frequency that is dependent on the total capacitance of the capacitors in the array connected to the largest part of the inductive element.

4. An oscillator as claimed in any preceding claim, wherein at least one of the capacitive arrays is connected to the whole of the inductive element.

5. An oscillator as claimed in any preceding claim, wherein the inductive element is formed of a single inductive coil, the at least one array being connected to only part of the inductive element by means of a tap on that coil.

6. An oscillator as claimed in any preceding claim, wherein the oscillator is configured to connect one or more of the switchably connectable capacitors to the inductive element responsive to a control signal from a digital controller.

7. An oscillator substantially as herein described with reference to the accompanying drawings.

8. A phase-locked loop comprising an oscillator as claimed in any preceding claim.

Figure 1.

Figure 2.

Figure 3.

Figure 4.

502

501 ~

503

~504.

Figure 5a

506 ~    570    ~ 507.

505. ~

508

~509.

Figure 5b.

Europäisches Patentamt
European Patent Office
Office européen des brevets

**EUROPEAN SEARCH REPORT**

Application Number

EP 11 18 2274

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/152293 A1 (MCCORQUODALE MICHAEL S [US] ET AL MCCORQUODALE MICHAEL SHANNON [US] ET) 13 July 2006 (2006-07-13) | 1-3,5-8 | INV. H03B5/12 |
| Y | * paragraph [0107] - paragraph [0128]; figures 3, 22,31 * | 4 | |
| X | US 2007/132522 A1 (LEE JA Y [KR] ET AL LEE JA YOL [KR] ET AL) 14 June 2007 (2007-06-14) | 1-3,7,8 | |
| Y | * figure 2 * | 4 | |
| Y | US 2006/226916 A1 (FLORESCU OCTAVIAN [US] ET AL) 12 October 2006 (2006-10-12) * figure 2 * | 4 | |

TECHNICAL FIELDS SEARCHED (IPC)

H03B

The present search report has been drawn up for all claims

| Place of search | Date of completion of the search | Examiner |
|---|---|---|
| Munich | 24 January 2012 | Schnabel, Florian |

**ANNEX TO THE EUROPEAN SEARCH REPORT
ON EUROPEAN PATENT APPLICATION NO.**

EP 11 18 2274

This annex lists the patent family members relating to the patent documents cited in the above-mentioned European search report.
The members are as contained in the European Patent Office EDP file on
The European Patent Office is in no way liable for these particulars which are merely given for the purpose of information.

24-01-2012

| Patent document cited in search report | Publication date | Patent family member(s) | Publication date |
|---|---|---|---|
| US 2006152293 A1 | 13-07-2006 | US 2006152293 A1<br>US 2006158267 A1<br>US 2006158268 A1<br>US 2009167444 A1 | 13-07-2006<br>20-07-2006<br>20-07-2006<br>02-07-2009 |
| US 2007132522 A1 | 14-06-2007 | KR 20070061176 A<br>US 2007132522 A1 | 13-06-2007<br>14-06-2007 |
| US 2006226916 A1 | 12-10-2006 | US 2006226916 A1<br>WO 2006110907 A2 | 12-10-2006<br>19-10-2006 |

EPO FORM P0459

For more details about this annex : see Official Journal of the European Patent Office, No. 12/82